# EUROPÄISCHE PATENTANMELDUNG

(11) **EP 1 806 425 A1**
(43) Veröffentlichungstag der Anmeldung: **11.07.2007**
(21) Anmeldenummer: 06000340.7
(22) Anmeldetag: 09.01.2006
(51) Int. Cl.: C23C 14/50

(54) **Verfahren und Vorrichtung zum Beschichten eines Bauteils**

(71) Anmelder: SIEMENS AKTIENGESELLSCHAFT, 80333 München (DE)
(72) Erfinder: Berndt, Thomas, 12524 Berlin (DE); Reymann, Helge, 14167 Berlin (DE)

(57) **Zusammenfassung**

Es wird ein Verfahren zum Beschichten eines Bauteils (21) zur Verfügung gestellt, in dem
- ein Verdampfen eines Beschichtungsmaterials aus einem Materialvorrat (5) bei niedrigem Umgebungsdruck herbeigeführt wird,
- das zu beschichtende Bauteil (21) derart in die Nähe des Materialvorrates (5) angeordnet wird, dass dadurch ein Ablagern von verdampftem Beschichtungsmaterial auf der Oberfläche des Bauteils (21) herbeigeführt wird, und
- eine Rotation des Bauteils (21) um eine Rotationsachse erfolgt, während es sich zum Herbeiführen des Ablagerns von Beschichtungsmaterial in der Nähe Materialvorrates (5) befindet. Die Rotationsachse wird vor oder während des Beschichtens aus einer Standardstellung zum Materialvorrat (5) hin geschwenkt.

## Beschreibung

Die Erfindung betrifft ein Verfahren zum Beschichten eines Bauteils, in dem ein Verdampfen eines Beschichtungsmaterials aus einem Materialvorrat bei niedrigem Umgebungsdruck herbeigeführt wird und das zu beschichtende Bauteil derart in der Nähe des Materialvorrats angeordnet wird, dass dadurch ein Ablagern von verdampftem Beschichtungsmaterial auf der Oberfläche des Bauteils herbeigeführt wird. Daneben betrifft die vorliegende Erfindung eine Vorrichtung zum Durchführen eines derartigen Verfahrens.

Turbinenbauteile, beispielsweise Lauf- und Leitschaufeln von Turbinen, werden mit wärmedämmenden Keramikbeschichtungen versehen, um ihre Widerstandsfähigkeit gegen die in einer Gasturbinenanlage auftretenden Temperaturen zu erhöhen. Als Wärmedämmbeschichtungen (TBC, thermal barrier coating) kommen beispielsweise Zirkonoxid-Beschichtungen (ZrO₂-Beschichtungen) zur Anwendung, die mit Yttriumoxid (Y₂O₃) wenigstens teilstabilisiert sind.

Das Aufbringen von auf Zirkonoxid basierenden Wärmedämmbeschichtungen auf eine Turbinenschaufel ist beispielsweise in US 4,676,994 beschrieben. Dort wird die Beschichtung mittels physikalischer Abscheidung aus der Gasphase (PVD, physical vapor deposition) aufgebracht. Eine Schmelze des Keramikmaterials wird dazu in einem Tiegel in einer Vakuumkammer soweit erhitzt, dass ein rascher Verdampfungsprozess eintritt. Verdampfte Keramikmoleküle lagern sich auf der Oberfläche des zu beschichtenden Bauteils ab. Damit eine gleichmäßige Beschichtung auf der gesamten Oberfläche entsteht, wird das Bauteil während der Beschichtung kontinuierlich mit einer festen Winkelgeschwindigkeit gedreht. Dadurch wird sichergestellt, dass alle Umfangsbereiche des Bauteils in regelmäßigen Abständen dem Tiegel mit der Schmelze zugewandt sind.
Eine Vorrichtung zum Beschichten eines Bauteils mittels eines sog. EBPVD-Verfahrens (EBPVD = electron beam physical vapor deposition) ist in WO 01/31080 A2 beschrieben. In einem derartigen Verfahren wird der rasche Verdampfungsprozess des Keramikmaterials mittels eines auf das Material gerichteten Elektronenstrahls herbeigeführt. Die in WO 01/31080 A2 beschriebene Vorrichtung umfasst eine Beschichtungskammer, in die Turbinenschaufeln eingebracht werden können. In der Kammer sind Ingots aus Keramikmaterial angeordnet, deren Oberfläche mittels des Elektronenstrahls soweit verflüssigt wird, dass das Keramikmaterial von der Oberfläche verdampft. Während des Verdampfens führen die in der Nähe der Ingots angeordneten Turbinenschaufeln eine Rotationsbewegung und/oder eine Oszillationsbewegung aus.

Gegenüber dem genannten Stand der Technik ist es Aufgabe der vorliegenden Erfindung, ein Verfahren und eine Vorrichtung zur Verfügung zu stellen, mit denen sich ein vorteilhaftes Beschichten von Bauteilen, insbesondere von Turbinenbauteilen wie etwa Turbinenschaufeln, realisieren lässt.

Diese Aufgabe wird durch ein Verfahren zum Beschichten eines Bauteils nach Anspruch 1 oder Anspruch 16 bzw. eine Vorrichtung zum Beschichten eines Bauteils nach Anspruch 9 oder Anspruch 17 gelöst. Die abhängigen Ansprüche enthalten vorteilhafte Ausgestaltungen der Erfindung.

Im erfindungsgemäßen Verfahren zum Beschichten eines Bauteils erfolgt ein Verdampfen eines Beschichtungsmaterials aus einem Materialvorrat bei niedrigem Umgebungsdruck. Das zu beschichtende Bauteil wird derart in der Nähe des Materialvorrates angeordnet, dass dadurch ein Ablagern von verdampftem Beschichtungsmaterial auf der Bauteiloberfläche herbeigeführt wird. Während des Beschichtungsprozesses erfolgt eine Rotation des Bauteils um eine Rotationsachse, die vor oder während des Beschichtens aus einer Standardstellung zum Materialvorrat hingeschwenkt wird. Das Verdampfen des Beschichtungsmaterials kann im erfindungsgemäßen Verfahren insbesondere durch Heizen des Materialvorrats mittels Elektronenstrahlheizung erfolgen.

Während im Stand der Technik die Richtung der Drehachse relativ zur Hauptverdampfungsrichtung des Materials senkrecht verläuft, wird sie im erfindungsgemäßen Verfahren in Richtung auf den Materialvorrat geschwenkt. Dies ermöglicht es bei Bauteilen, die zueinander senkrechte oder nahezu senkrechte Abschnitte aufweisen, wie etwa Turbinenschaufeln mit einem Schaufelblatt und einer zum Schaufelblatt nahezu senkrecht verlaufenden Schaufelplattform, die zueinander senkrechten Oberflächen beide mit einer gleichmäßigen Beschichtung zu versehen. Im Stand der Technik liegt die Rotationsachse dagegen so, dass bei Turbinenschaufeln zwar die Oberfläche des Schaufelblattes günstig zur Hauptverdampfungsrichtung liegt, die Oberfläche der Schaufelplattform jedoch weitgehend parallel zu dieser Verdampfungsrichtung verläuft. Es ist im Stand der Technik daher schwierig, sowohl Schaufelplattform als auch Schaufelblatt mit einer gleichmäßigen Beschichtung zu versehen. Mit dem erfindungsgemäßen Verfahren ist es dagegen möglich, sowohl die Oberfläche von Schaufelplattform als auch die Oberfläche des Schaufelblattes mit einer gleichmäßigen und im Wesentlichen gleich dicken Beschichtung zu versehen, da sowohl die Oberfläche des Schaufelblattes als auch die Oberfläche der Schaufelplattform in einem günstigen Winkel zur Hauptverdampfungsrichtung gebracht werden können. Ähnliches gilt auch für andere zueinander weitgehend senkrechten zu beschichtende Oberflächen.

Vorteilhafterweise erfolgt die Schwenkbewegung während des Beschichtens, sodass jede der zueinander weitgehend Senkrechten Oberflächen über einen bestimmten Zeitraum einen günstigen Winkel zur Hauptverdampfungsrichtung aufweisen kann. Besonders vorteilhaft ist es hierbei, wenn sowohl eine Schwenkbewegung der Rotationsachse zum Materialvorrat hin als auch vom Materialvorrat weg erfolgt. Auf diese Weise lassen sich beispielsweise Leitschaufeln einer Turbine gleichmäßig beschichten, die an beiden Enden des Schaufelblattes Schaufelplattformen aufweisen, deren einander gegenüber liegenden Oberflächen im Wesentlichen senkrecht zu den Oberflächen des Schaufelblattes verlaufen. Eine besonders gleichmäßige Beschichtung kann hierbei erzielt werden, wenn die Schwenkbewegung in einer periodischen Weise um die Standardstellung erfolgt, welche eine Mittelstellung der Rotationsachse darstellt.

Als geeignete Winkel, um die die Rotationsachse zum Materialvorrat hin oder vom Materialvorrat weg verschwenkt werden kann, haben sich Winkel von bis zu 30° bewährt.

In einer weiteren, vorteilhaften Ausgestaltung der Erfindung erfolgt zudem während des Beschichtens eine Axialbewegung des Bauteils entlang einer Richtung, die der Richtung der Rotationsachse in der Standardstellung entspricht. Diese Axialbewegung, auch Wobble-Bewegung genannt, kann dazu beitragen, Inhomogenitäten im vom Verdampfungsvorrat ausgehenden Kegel aus verdampftem Material auszugleichen.

Das erfindungsgemäße Verfahren eignet sich insbesondere zum Beschichten von Turbinenbauteilen mit wärmedämmenden Keramikbeschichtungen.

Eine erfindungsgemäße Vorrichtung zum Beschichten eines Bauteils umfasst eine Unterdruckkammer, einen in der Unterdruckkammer angeordneten Materialvorrat mit Beschichtungsmaterial, beispielsweise in Form eines Materialblocks (sog. Ingot), eine Heizung zum Heizen der Oberfläche des Materialvorrats derart, dass Beschichtungsmaterial von der Oberfläche des Materialvorrats verdampft, und eine Halterung zum Halten wenigstens eines zu beschichtenden Bauteils. Die Halterung ermöglicht eine Rotation des Bauteils um eine Rotationsachse. Sie ist derart ausgestaltet, dass sie außerdem ein Schwenken der Rotationsachse aus einer Standardrichtung wenigstens zum Materialvorrat hin zulässt. Die erfindungsgemäße Vorrichtung eignet sich insbesondere zum Durchführen des erfindungsgemäßen Verfahrens und bietet daher die mit Bezug auf das Verfahren erwähnten Vorteile.

Besonders vorteilhaft ist es, wenn die Halterung derart ausgestaltet ist, dass sie ein Schwenken der Rotationsachse aus der Standardrichtung sowohl zum Materialvorrat hin als auch vom Materialvorrat weg zulässt. Die möglichen Schwenkwinkel zwischen der Standardrichtung und der Rotationsachse können insbesondere im Bereich zwischen -30° und 30° liegen. Zudem kann die Halterung derart ausgestaltet sein, dass sie auch ein axiales Verschieben des Bauteils entlang der Rotationsachse ermöglicht.

In einer vorteilhaften Weiterbildung der erfindungsgemäßen Vorrichtung umfasst diese eine Steuereinheit zum Steuern der von der Halterung zugelassenen Bewegung während des Beschichtungsvorgangs. Mittels geeigneter Steuerroutinen können so die für das zu beschichtende Bauteil günstigsten Bewegungsabläufe aus Schwenken der Rotationsachse und/oder Verschieben des Bauteils entlang der Rotationsachse bei gleichzeitiger Rotation des Bauteils um die Rotationsachse realisiert werden.

Zum Heizen der Oberfläche des Materialvorrats umfasst die Vorrichtung vorteilhafterweise eine Elektronenstrahlheizung.

Die erfindungsgemäße Vorrichtung kann insbesondere derart ausgestaltet sein, dass die Halterung zum Halten eines Turbinenbauteils, insbesondere einer Turbinenschaufel, geeignet ist und der Materialvorrat ein Keramikmaterial als Beschichtungsmaterial enthält. Derart ausgestaltet eignet sich die erfindungsgemäße Vorrichtung zum Aufbringen einer keramischen Wärmedämmbeschichtung auf ein Turbinenbauteil wie etwa eine Lauf- oder Leitschaufel einer Gasturbinenanlage.

Im Verfahren zum Beschichten eines Bauteils, insbesondere eines Turbinenbauteils wie etwa einer Turbinenschaufel, gemäß Anspruch 16 wird ein Verdampfen eines Beschichtungsmaterials aus einem Materialvorrat bei niedrigem Umgebungsdruck herbeigeführt. Das zu beschichtende Bauteil wird dabei derart in der Nähe des Materialvorrates angeordnet, dass dadurch ein Ablagern von verdampftem Beschichtungsmaterial auf der Oberfläche des Bauteils herbeigeführt wird. Außerdem erfolgt ein Verschieben des Materialvorrats relativ zum Bauteil während des Beschichtens. Dadurch kann der Materialvorrat besonders günstig zum zu beschichtenden Bauteil angeordnet werden. Die Durchführung diese Verfahrens kann mittels einer Vorrichtung zum Beschichten eines Bauteils nach Anspruch 17 erfolgen, welche mit einer Unterdruckkammer, einem in der Unterdruckkammer angeordneten Materialvorrat mit Beschichtungsmaterial, einer Heizung zum Heizen der Oberfläche des Materialvorrates derart, dass Beschichtungsmaterial von der Oberfläche des Materialvorrates verdampft, und einer Halterung zum Halten wenigstens eines zu beschichtenden Bauteils ausgestattet ist. In dieser Vorrichtung ist der Materialvorrat relativ zur Halterung verschiebbar angeordnet. Das Verfahren nach Anspruch 16 und die Vorrichtung nach Anspruch 17 können insbesondere auch mit dem Verfahren nach Anspruch 1 bzw. der Vorrichtung nach Anspruch 9 kombiniert werden.

Weitere Merkmale, Eigenschaften und Vorteile der vorliegenden Erfindung ergeben sich aus der nachfolgenden Beschreibung von Ausführungsbeispielen unter Bezugnahme auf die beiliegenden Figuren.
- Fig. 1: zeigt beispielhaft eine Gasturbine in einem Längsteilschnitt.
- Fig. 2: zeigt in perspektivischer Ansicht eine Laufschaufel oder Leitschaufel einer Strömungsmaschine.
- Fig. 3: zeigt eine Brennkammer einer Gasturbine
- Fig. 4: zeigt in einer stark schematisierten Darstellung eine EBPVD-Vorrichtung in einer geschnittenen Seitenansicht.
- Fig. 5a-5c: zeigen verschiedene Schwenkpositionen der Bauteilhalterung der Vorrichtung aus Fig. 4
- Fig. 6: zeigt die möglichen Bewegungsrichtungen einer Turbinenschaufel während des Beschichtens in der Vorrichtung aus Fig. 4.

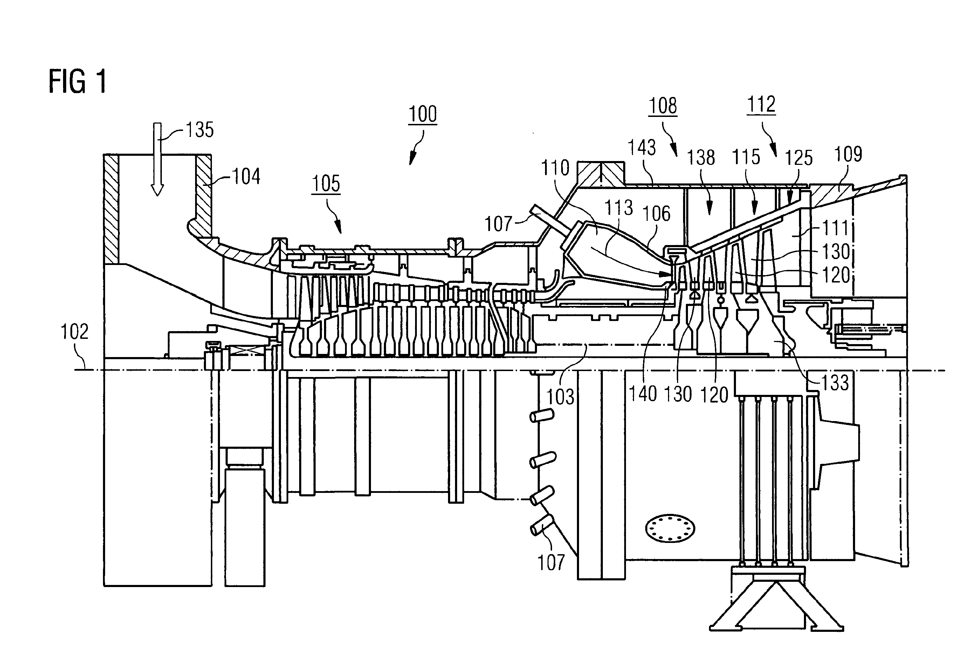

Die Figur 1 zeigt beispielhaft eine Gasturbine 100 in einem Längsteilschnitt. Die Gasturbine 100 weist im Inneren einen um eine Rotationsachse 102 drehgelagerten Rotor 103 auf, der auch als Turbinenläufer bezeichnet wird. Entlang des Rotors 103 folgen aufeinander ein Ansauggehäuse 104, ein Verdichter 105, eine beispielsweise torusartige Brennkammer 110, insbesondere Ringbrennkämmer 106, mit mehreren koaxial angeordneten Brennern 107, eine Turbine 108 und das Abgasgehäuse 109.

Die Ringbrennkammer 106 kommuniziert mit einem beispielsweise ringförmigen Heißgaskanal 111. Dort bilden beispielsweise vier hintereinandergeschaltete Turbinenstufen 112 die Turbine 108.

Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.

An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 106 auskleidenden Hitzeschildsteinen am meisten thermisch belastet.

Um den dort herrschenden Temperaturen standzuhalten, können diese mittels eines Kühlmittels gekühlt werden.

Ebenso können Substrate der Bauteile eine gerichtete Struktur aufweisen, d.h. sie sind einkristallin (SX-Struktur) oder weisen nur längsgerichtete Körner auf (DS-Struktur).

Als Material für die Bauteile, insbesondere für die Turbinenschaufel 120, 130 und Bauteile der Brennkammer 110 werden beispielsweise eisen-, nickel- oder kobaltbasierte Superlegierungen verwendet. Solche Superlegierungen sind beispielsweise aus der EP 1 204 776 B1, EP 1 306 454, EP 1 319 729 A1, WO 99/67435 oder WO 00/44949 bekannt; diese Schriften sind Teil der Offenbarung.

Ebenso können die Schaufeln 120, 130 Beschichtungen gegen Korrosion (MCrA1X; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden bzw. Hafnium). Solche Legierungen sind bekannt aus der EP 0 486 489 B1, EP 0 786 017 B1, EP 0 412 397 B1 oder EP 1 306 454 A1, die Teil dieser Offenbarung sein sollen.

Auf der MCrAlX kann noch eine Wärmedämmschicht vorhanden sein, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

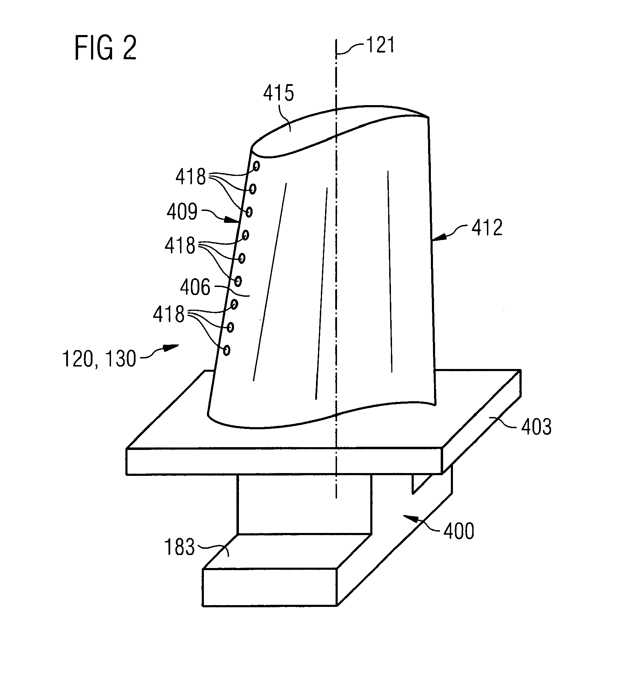

Figur 2 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 auf. Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).

Der Schaufelfuß 183 ist beispielsweise als Hammerkopf ausgestaltet. Andere Ausgestaltungen als Tannenbaum- oder Schwalbenschwanzfuß sind möglich.

Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet. Solche Superlegierungen sind beispielsweise aus der EP 1 204 776 B1, EP 1 306 454, EP 1 319 729 A1, WO 99/67435 oder WO 00/44949 bekannt; diese Schriften sind Teil der Offenbarung. Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind. Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt. Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen. Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures). Solche Verfahren sind aus der US-PS 6,024,792 und der EP 0 892 090 A1 bekannt; diese Schriften sind Teil der Offenbarung.

Ebenso können die Schaufeln 120, 130 Beschichtungen gegen Korrosion oder Oxidation (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1, die Teil dieser Offenbarung sein sollen.

Auf der MCrAlX kann noch eine Wärmedämmschicht vorhanden sein und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid. Durch geeignete Beschichtungsverfahren wie z.B. Elektronenstrahlverdampfen (EB-PVD) werden stängelförmige Körner in der Wärmedämmschicht erzeugt.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

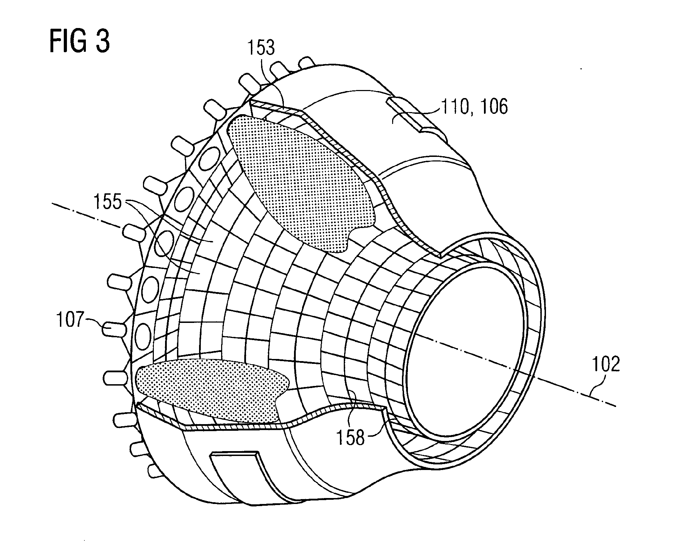

Die Figur 3 zeigt eine Brennkammer 110 einer Gasturbine. Die Brennkammer 110 ist beispielsweise als so genannte Ringbrennkammer ausgestaltet, bei der eine Vielzahl von in Umfangsrichtung um die Rotationsachse 102 herum angeordneten Brennern 107 in einen gemeinsamen Brennkammerraum münden. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.

Jedes Hitzeschildelement 155 ist arbeitsmediumsseitig mit einer besonders hitzebeständigen Schutzschicht ausgestattet oder aus hochtemperaturbeständigem Material gefertigt. Dies können massive keramische Steine oder Legierungen mit MCrAlX und/oder keramischen Beschichtungen sein. Die Materialien der Brennkammerwand und deren Beschichtungen können ähnlich der Turbinenschaufeln sein.

Aufgrund der hohen Temperaturen im Inneren der Brennkammer 110 kann zudem für die Hitzeschildelemente 155 bzw. für deren Halteelemente ein Kühlsystem vorgesehen sein.

Die Brennkammer 110 ist insbesondere für eine Detektion von Verlusten der Hitzeschildelemente 155 ausgelegt. Dazu sind zwischen der Brennkammerwand 153 und den Hitzeschildelementen 155 eine Anzahl von Temperatursensoren 158 positioniert.

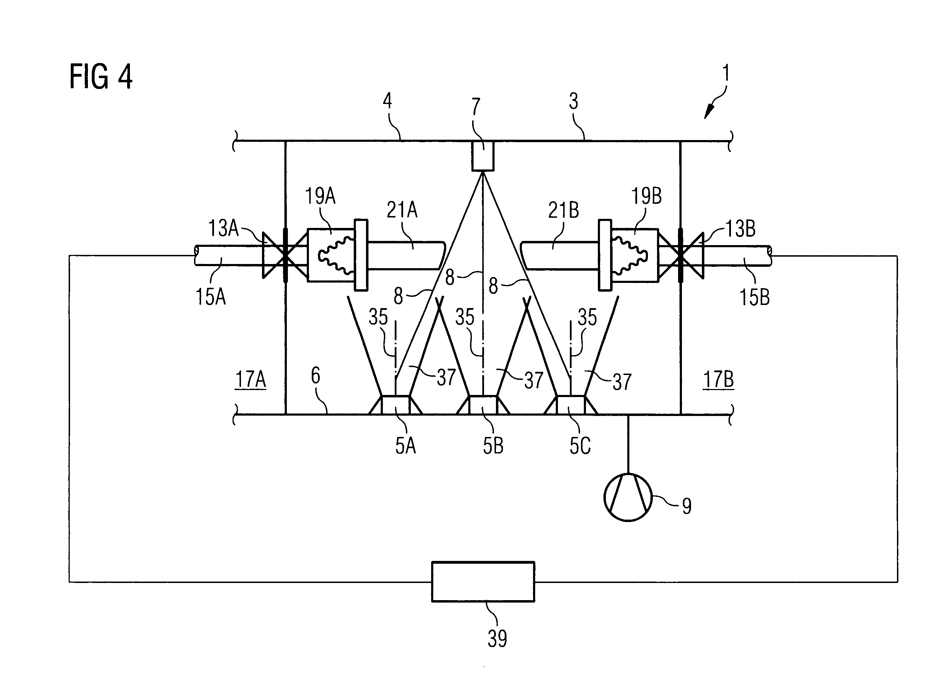

Als ein Beispiel für eine erfindungsgemäße Vorrichtung zum Beschichten eines Bauteils zeigt Fig. 4 eine Anlage zum Durchführen eines EBPVD-Prozesses in einer stark schematisierten Darstellung. Die Anlage und der Beschichtungsprozess werden nachfolgend mit Bezug auf das Beschichten einer Gasturbinenschaufel beschrieben. Es sei jedoch an dieser Stelle darauf hingewiesen, dass die Vorrichtung und das erfindungsgemäße Verfahren auch zum Beschichten anderer Bauteile, insbesondere anderer Turbinenbauteile Verwendung finden kann.

Auf die Turbinenschaufel wird eine keramische Wärmedämmschicht aufgebracht, die im vorliegenden Ausführungsbeispiel als Zirkonoxid-Schicht (ZrO₂-Schicht) ausgebildet ist, die mit Yttrium (Y) zumindest teilstabilisiert ist. Es können jedoch auch andere, insbesondere keramische Beschichtungen, auf das zu beschichtende Bauteil aufgebracht werden.

Die in Fig. 4 gezeigte EBPVD-Vorrichtung 1 umfasst eine Unterdruckkammer 3, drei Ingots 5a bis 5c aus Beschichtungsmaterial, die einen Materialvorrat für das Beschichtungsmaterial darstellen, wenigstens eine Elektronenkanone 7, die derart angeordnet und ausgebildet ist, dass ein Elektronenstrahl auf die Ingots 5a bis 5c gerichtet werden kann, sowie eine Vakuumpumpe 9, mit sich der Druck in der Unterdruckkammer 3 reduzieren lässt. Während des Beschichtens ist die Unterdruckkammer 3 mit Hilfe der Vakuumpumpe 9 auf einen niedrigen Druck, vorzugsweise auf einen Druck von nicht mehr als 1 x 10-⁵ bar (1 Pa), evakuiert. Die Temperatur der Turbinenschaufel wird während des Beschichtens auf 900°C bis 1200°C gehalten.

Die Elektronenkanone 7 ist derart relativ zu den Ingots 5a bis 5c angeordnet, dass ihr Elektronenstrahl 8 ungehindert von in der Unterdruckkammer 3 befindlichen Bauteilen 21a, 21b auf die dem Kammerinneren zugewandten Oberflächen der Ingots 5a bis 5c gerichtet werden kann. Dazu kann die Elektronenkanone 7 den am Boden 6 der Unterdruckkammer 3 angeordneten Ingots 5a bis 5c gegenüberliegend an der Decke 4 der Unterdruckkammer 3 angeordnet sein, wie dies in Fig. 4 dargestellt ist. Alternativ ist es jedoch auch möglich, die Elektronenkanone 7 an einer der Seitenwände der Unterdruckkammer 3 anzubringen. Es sei außerdem darauf hingewiesen, dass obwohl immer von einer Elektronenkanone 7 in der Einzahl gesprochen wird, auch mehrere Elektronenkanonen 7 vorhanden sein können, beispielsweise je eine Elektronenkanone 7 pro Ingot. Wenn wie im vorliegenden Ausführungsbeispiel lediglich eine Elektronenkanone 7 vorhanden ist, so heizt der Elektronenstrahl 8 im Wechsel die Oberfläche eines jeden Ingots 5a, 5b, 5c. Hierzu muss die Elektronenkanone 7 derart ausgestaltet sein, dass sich der Elektronenstrahl 8 in raschem Wechsel auf alle drei Ingots 5a, 5b, 5c richten lassen kann.

Die Unterdruckkammer 3 umfasst außerdem zwei einander gegenüberliegende betätigbare Absperrorgane. Diese dienen als verschließbare Öffnungen, durch die Manipulatoren 15a, 15b von Vorbereitungskammern 17a, 17b aus in die Unterdruckkammer 3 eingeführt werden können. Die Manipulatoren 15a, 15b sind mit Halterungen 19a, 19b versehen, die zum Halten der zu beschichtenden Bauteile 21a, 21b, im vorliegenden Ausführungsbeispiel also zum Halten von Gasturbinenschaufeln, ausgebildet sind. Die Vorbereitungskammern 17a, 17b können einzeln von der Unterdruckkammer 3 gelöst werden, um die Turbinenschaufeln 21a, 21b auszuwechseln. Hierzu wird der Manipulator 15a, 15b aus der Unterdruckkammer 3 herausgezogen, bis er sich vollständig in der Vorbereitungskammer 17a bzw. 17b befindet. Das Ventil 13a, 13b kann dann geschlossen werden, sodass die Vorbereitungskammer von der Unterdruckkammer 3 entfernt werden kann, ohne den niedrigen Druck in der Unterdruckkammer 3 zu beeinträchtigen.

In einer besonderen Variante der EBPVD-Vorrichtung 1 sind die Ingots 5a bis 5c entlang des Kammerbodens 6 relativ zu den Manipulatoren 19a, 19b - und damit relativ zu den gehaltenen Turbinenschaufeln 21a, 21b - verschiebbar angeordnet. Sie können dann während des Beschichtungsvorganges relativ zu den Turbinenschaufeln verschoben werden um eine günstige Position einzunehmen. Das Verschieben der Ingots 5a bis 5c kann insbesondere oszillierend, also in einer Hin- und Herbewegung erfolgen.

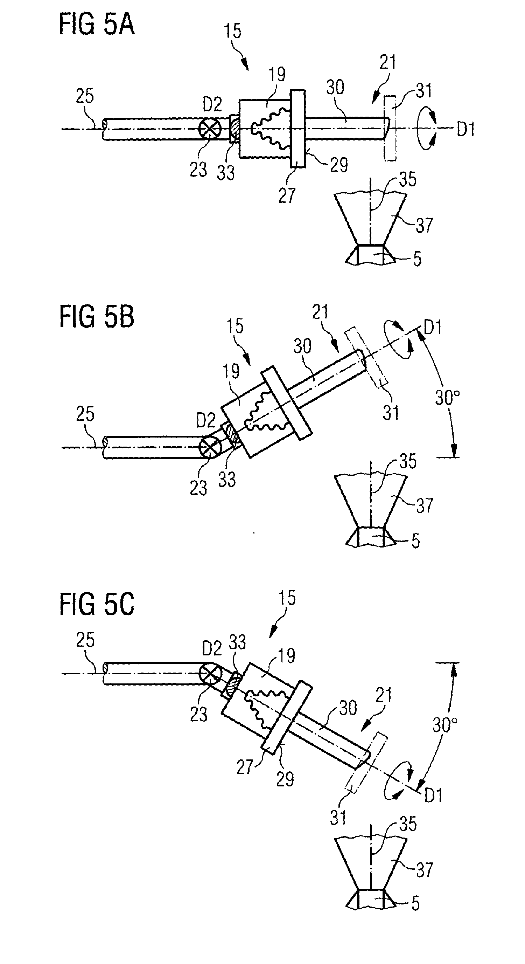

Ein Manipulator 15 ist in den Fig. 5a bis 5c vergrößert dargestellt. Neben der Halterung 19 weist der Manipulator 15 eine Kippachse 23 auf, welche senkrecht zu seiner zentralen Längsachse 25 verläuft. Um diese Kippachse 23 kann die Halterung 19, und damit die gehaltene Turbinenschaufel 15 relativ zur Längsachse 25 um bis zu 30° zu den Ingots 5a bis 5c hin oder von den Ingots 5a bis 5c weg geschwenkt werden. Die Richtung der Längsachse 25 des Manipulators 15 stellt eine Standardrichtung dar, welche die Mittelstellung der Halterung 19 definiert. Die Fig. 5b und 5c zeigen eine Verschwenkung der Halterung 19 um 30° gegenüber dieser Mittelstellung von den Ingots weg (5b) bzw. zu den Ingots hin (5c).

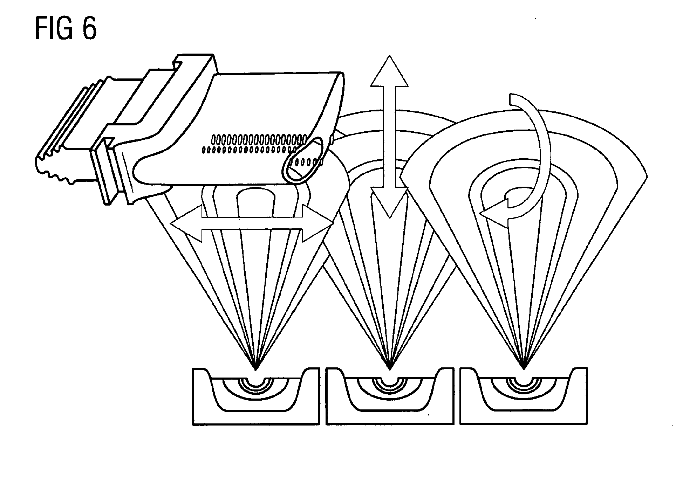

Die Halterung 19 ist außerdem mit einem Drehgelenk 33 versehen, mit dessen Hilfe sie samt daran angeordneter Turbinenschaufel 21 um die Längsachse 25 der Halterung gedreht werden kann. Zudem kann der Manipulator 15 entlang der Längsachse 25 verschoben werden, sodass sich für eine in der Halterung 19 gehaltene Turbinenschaufel 21 die in Fig. 6 dargestellten Bewegungsmöglichkeiten ergeben.

Nachfolgend wird das Beschichten eines Bauteils in der dargestellten EBPVD-Vorrichtung 1 beschrieben. Dazu werden die Manipulatoren 15a, 15b mit in den Halterungen 19a, 19b befestigten Turbinenschaufeln 21a, 21b von den Vorbereitungskammern aus in die Unterdruckkammer 3 eingebracht. Mittels der Elektronenkanone 7 erfolgt eine Elektronenstrahlheizung der dem Kammerinneren zugewandten Oberflächen der Keramikingots 5a bis 5c, sodass die Oberflächen aufgeschmolzen werden und ein rascher Verdampfungsprozess eintritt.

Das Verdampfen des Keramikmaterials findet im Wesentlichen in einer Hauptverdampfungsrichtung statt, die in etwa der Mittellinie 35 der in den Figuren 4 und 5 dargestellten Verdampfungskegel 37 entspricht. Das verdampfte Keramikmaterial adsorbiert auf der Oberfläche der Turbinenschaufel 21a, 21b und führt so zu einer Keramikbeschichtung. Damit die Turbinenschaufel 21a, 21b über den gesamten Umfang gleichmäßig beschichtet wird, rotiert sie während des Beschichtungsprozesses um die Längsachse der Halterung, die in Fig. 4 senkrecht zur Verdampfungsrichtung verläuft (vgl. auch Fig. 5a) und mit der Längsachse 25 des Manipulators 15 übereinstimmt. Auf diese Weise ist während einer Rotationsperiode jeder Oberflächenabschnitt des Schaufelblattes 30 einmal den Ingots 5 zugewandt. Wie Fig. 5a aber auch zu entnehmen ist, verläuft die Oberfläche 29 der Schaufelplattform 27 weitgehend senkrecht zur Hauptverdampfungsrichtung 35, sodass nur ein relativ geringer Materialanteil in Richtung auf diese Oberfläche 29 verdampft. Infolgedessen ist die Adsorptionsrate relativ gering. Wenn nun die Längsachse der Halterung 19 in Richtung auf die Ingots 5 geschwenkt wird, wie dies in Fig. 5c dargestellt ist, so kann damit die Adsorptionsrate auf der Oberfläche 29 der Schaufelplattform 27 erhöht werden. Die Rotation der Turbinenschaufel 21 um die Längsachse der Halterung führt dabei dazu, dass auch solche Bereiche der Schaufelplattform 27, die während eines Teils der Umdrehung im Schatten der Schaufelblattes 30 liegen, während eines anderen Teils der Umdrehung den Ingots direkt zugewandt sind. Auf diese Weise ist auch eine rasche und gleichmäßige Beschichtung der Schaufelplattformen möglich.

Die in Fig. 5b dargestellte, um bis zu 30° von den Ingots weg verschwenkte Stellung der Turbinenschaufel 21 ist insbesondere für solche Turbinenschaufeln von Bedeutung, die an beiden Enden Schaufelplattformen aufweisen, wie dies beispielsweise bei Leitschaufeln der Fall ist. Die Anordnung einer solchen zweiten Schaufelplattform 31 ist in den Figuren 5a bis 5c gestrichelt angedeutet. Während die den Ingots 5 zugewandte Schwenkstellung (Fig. 5c) für die eine Schaufelplattform vorteilhaft ist, ist die von den Ingots 5 abgewandte Schwenkstellung (Fig. 5b) für die andere Schaufelplattform vorteilhaft. Insbesondere bietet es sich in diesem Fall an, die Turbinenschaufel periodisch um die Längsachse 25 des Manipulators 15 hin und her zu schwenken. Dadurch wird erreicht, dass beide Schaufelplattformen gleichmäßig gut beschichtet werden können. Während des gesamten Beschichtungsprozesses kann auch eine Hin- und Herbewegung der Schaufel 21 und/oder der Ingots 5a bis 5c insbesondere entlang der Längsachse 25 des Manipulators 15 erfolgen. Die Kombination der in Fig. 6 dargestellten Bewegungen ermöglicht ein besonders gleichmäßiges Beschichten von Bauteilen.

## Patentansprüche

1. Verfahren zum Beschichten eines Bauteils (21), in dem
- ein Verdampfen eines Beschichtungsmaterials aus einem Materialvorrat (5) bei niedrigem Umgebungsdruck herbeigeführt wird,
- das zu beschichtende Bauteil (21) derart in die Nähe des Materialvorrates (5) angeordnet wird, dass **dadurch** ein Ablagern von verdampftem Beschichtungsmaterial auf der Oberfläche des Bauteils (21) herbeigeführt wird, und
- eine Rotation des Bauteils (21) um eine Rotationsachse erfolgt, während es sich zum Herbeiführen des Ablagerns von Beschichtungsmaterial in der Nähe Materialvorrates (5) befindet,
**dadurch gekennzeichnet, dass**
die Rotationsachse vor oder während des Beschichtens aus einer Standardstellung zum Materialvorrat (5) hin geschwenkt wird.

2. Verfahren nach Anspruch 1,
**dadurch gekennzeichnet, dass**
die Schwenkbewegung während des Beschichtens erfolgt.

3. Verfahren nach Anspruch 2,
**dadurch gekennzeichnet, dass**
eine Schwenkbewegung der Rotationsachse sowohl zum Materialvorrat (5) hin, als auch vom Materialvorrat (5) weg erfolgt.

4. Verfahren nach Anspruch 3,
**dadurch gekennzeichnet, dass**
die Schwenkbewegung in periodischer Weise um die Standardstellung erfolgt, welche eine Mittelstellung der Rotationsachse darstellt.

5. Verfahren nach einem der Ansprüche 1 bis 4,
**dadurch gekennzeichnet, dass**
die Verschwenkung der Rotationsachse gegenüber der Standardstellung nicht mehr als 30° beträgt.

6. Verfahren nach einem der Ansprüche 1 bis 5,
**dadurch gekennzeichnet, dass**
während des Beschichtens eine Axialbewegung des Bauteils (5) in der Richtung erfolgt, die der Richtung der Rotationsachse in Standardstellung entspricht.

7. Verfahren nach einem der Ansprüche 1 bis 6,
**dadurch gekennzeichnet, dass**
das Bauteil ein Turbinenbauteil (21) und die Beschichtung eine wärmedämmende Keramikbeschichtung ist.

8. Verfahren nach einem der Ansprüche 1 bis 7,
**dadurch gekennzeichnet, dass**
das Verdampfen des Beschichtungsmaterials durch Heizen des Materialvorrates (5) mittels Elektronenstrahlheizung (8) herbeigeführt wird.

9. Vorrichtung (1) zum Beschichten eines Bauteils (21) mit
- einer Unterdruckkammer (3),
einem in der Unterdruckkammer (3) angeordneten Materialvorrat (5) mit Beschichtungsmaterial,
- einer Heizung (7, 8) zum Heizen der Oberfläche des Materialvorrates (5) derart, dass Beschichtungsmaterial von der Oberfläche des Materialvorrates (5) verdampft, und
- einer Halterung (19) zum Halten wenigstens eines zu beschichtenden Bauteils (21), welche eine Rotation des Bauteils (21) um eine Rotationsachse ermöglicht,
**dadurch gekennzeichnet, dass**
die Halterung (19) derart ausgestaltet ist, dass sie ein Schwenken der Rotationsachse aus einer Standardrichtung wenigstens zum Materialvorrat (5) hin zulässt.

10. Vorrichtung nach Anspruch 9,
**dadurch gekennzeichnet, dass**
die Halterung (19) derart ausgestaltet ist, dass sie ein Schwenken der Rotationsachse aus der Standardrichtung sowohl zum Materialvorrat (5) hin als auch vom Materialvorrat (5) weg zulässt.

11. Vorrichtung nach Anspruch 9 oder 10,
**dadurch gekennzeichnet, dass**
die möglichen Schwenkwinkel zwischen der Standardrichtung und der Rotationsachse im Bereich zwischen -30° und 30° liegen.

12. Vorrichtung nach Anspruch 9, 10 oder 11,
**dadurch gekennzeichnet, dass**
die Halterung (19) derart ausgestaltet ist, dass sie ein axiales Verschieben des Bauteils (21) entlang derjenigen Richtung zulässt, die der Richtung der Rotationsachse in Standardstellung entspricht.

13. Vorrichtung nach einem der Ansprüche 9 bis 12,
**gekennzeichnet durch**
eine Steuereinheit (39) zum Steuern der von der Halterung (19) zugelassenen Bewegungen während des Beschichtungsvorganges.

14. Vorrichtung nach einem der Ansprüche 9 bis 13,
**dadurch gekennzeichnet, dass**
die Heizung zum Heizen (7, 8) der Oberfläche des Materialvorrates (5) eine Elektronenstrahlheizung ist.

15. Vorrichtung nach einem der Ansprüche 9 bis 14,
**dadurch gekennzeichnet, dass**
die Halterung (19) zum Halten eines Turbinenbauteils (21) ausgestaltet ist und der Materialvorrat (5) ein Keramikmaterial als Beschichtungsmaterial enthält.

16. Verfahren zum Beschichten eines Bauteils (21),
in dem
- ein Verdampfen eines Beschichtungsmaterials aus einem Materialvorrat (5) bei niedrigem Umgebungsdruck herbeigeführt wird, und
- das zu beschichtende Bauteil (21) derart in die Nähe des Materialvorrates (5) angeordnet wird, dass **dadurch** ein Ablagern von verdampftem Beschichtungsmaterial auf der Oberfläche des Bauteils (21) herbeigeführt wird,
**dadurch gekennzeichnet, dass**
der Materialvorrat (5) während des Beschichtens relativ zum Bauteil (21) verschoben wird.

17. Vorrichtung (1) zum Beschichten eines Bauteils (21) mit
- einer Unterdruckkammer (3),
- einem in der Unterdruckkammer (3) angeordneten Materialvorrat (5) mit Beschichtungsmaterial,
- einer Heizung (7, 8) zum Heizen der Oberfläche des Materialvorrates (5) derart, dass Beschichtungsmaterial von der Oberfläche des Materialvorrates (5) verdampft, und
- einer Halterung (19) zum Halten wenigstens eines zu beschichtenden Bauteils (21),
**dadurch gekennzeichnet, dass** der Materialvorrat (5) relativ zur Halterung (19) verschiebbar angeordnet ist.
